# EUROPEAN PATENT APPLICATION

(11) **EP 1 124 136 A1**
(43) Date of publication of application: **16.08.2001**
(21) Application number: 01100194.8
(22) Date of filing: 17.01.2001
(51) Int. Cl.: G01R 31/04

(54) **Electrical connection testing device and method for connector terminals**

(30) Priority: 10.02.2000 JP 2000033643; 22.02.2000 JP 2000044583
(71) Applicant: Sumitomo Wiring Systems, Ltd., Yokkaichi-City, Mie, 510-8503 (JP)
(72) Inventor: Nagano, Yuuji, c/o S.D. Engineering, Ltd., Yokkaichi-city, Mie, 510-8503 (JP); Suzuki, Nobuhiro, c/o S.D. Engineering, Ltd., Yokkaichi-city, Mie, 510-8503 (JP); Nishino, Akira, c/o S.D. Engineering, Ltd., Yokkaichi-city, Mie, 510-8503 (JP)
(74) Representative: Müller-Boré & Partner Patentanwälte

(57) **Abstract**

An electrical connection testing device is provided with a connector holder (12), first and second probe holders (13,14) which are successively arranged such that the connector holder (12) and the second probe holder are movable toward and away from the connector holder (12). A pushing mechanism (18) for pushing a receiving surface (14d) of the second probe holder (14) at the opposite side from the connector holder (12) is so coupled with the second probe holder (14) as to be movable toward and away from the second probe holder (14). The second probe holder (14) and the connector holder (12) are moved according to the movement of the pushing mechanism (18), thereby being positioned at testing positions (P1) where probes (16,17) are inserted into testing holes (1a) of a connector (C) from opposite sides or at retracted positions (P2) where the connector (C) can be taken out of a connector holder (12).

## Description

The present invention relates to an electrical connection testing device and to an electrical connection testing method for terminal fittings accommodated in a connector and particularly an electrical connection testing device and method for testing electrical connections of terminal fittings by inserting testing probes through testing holes formed in side walls of a connector housing extending in a direction normal to a terminal inserting direction and bringing them sideways into contact with the terminal fittings inserted and locked in cavities.

Electrical connection testing devices for terminal fittings accommodated in a connector test electrical connections by inserting testing probes into cavities in the connector through openings formed at the engaging side with a mating connector and bringing the leading ends of the probes into contact with the terminal fittings inserted and locked in the cavities. However, in the case of female terminal fittings, there is a problem that only hollow portions of the female terminal fittings can be seen from the probe inserting side and end surfaces of the terminal fittings with which the probes are brought into contact cannot be seen. Further, if the probe are inserted toward the terminal fittings in the same direction as the inserting direction of the mating terminal fittings, problems may arise in terms of reliability in electrical contact and connection precision during connection with a mating connector if the probes damage the terminal fittings and/or connector.

Thus, in the case of testing the electrical connections of female terminal fittings, an electrical connecting testing device is expected to be of the side probe type with which testing holes are formed in side walls of a connector housing extending in a direction normal to a terminal inserting direction and the testing probes are inserted through these holes instead of being inserted through the openings at the leading ends of cavities, thereby being brought into contact with the sides of the terminal fittings.

The applicant of the present invention proposed an electrical connection testing apparatus of the side probe type as shown in FIG. 17 in Japanese Unexamined Patent Publication No. 6-258373. This device is constructed such that probes 2 to be inserted into testing holes 1a formed in one side wall of a connector 1 are L-shaped as shown and leading end portions bent to extend downward are inserted into the testing holes 1a.

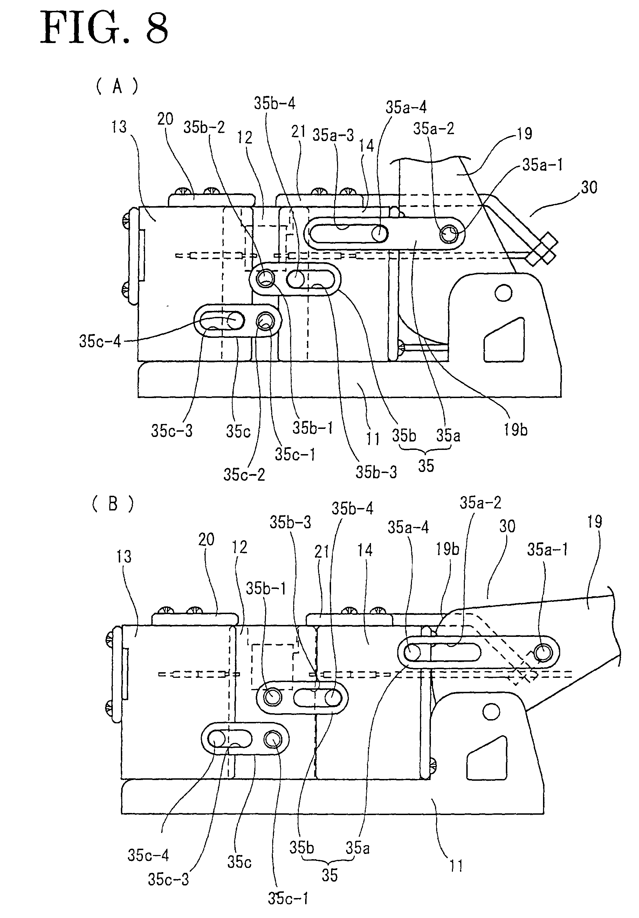

In the case of the above construction, the testing holes 1a can be formed only in one side wall (upper wall in FIG. 8) of the connector 1, in other words, only one stage of cavities can be provided in the connector 1. Many connectors are formed with cavities arrayed at two stages, and the above device cannot be applied to such connectors.

In view of the above problem, an object of the present invention is to provide an electrical connection testing device of the side probe type and an electrical connection method which allow for an easy testing of two stage connectors.

This object is solved according to the invention by an electrical connection testing device according to claim 1 and by an electrical connection method according to claim 15. Preferred embodiments of the invention are subject of the dependent claims.

According to the invention, there is provided an electrical connection testing device for testing electrical connections of terminal fittings at least partly accommodated in a connector by at least partly inserting testing probes through testing holes formed in side walls of a connector housing extending in a direction at an angle different from 0° or 180°, preferably substantially normal to a terminal mating or inserting direction of the terminal fittings with mating terminal fittings, so that the testing probes can be preferably elastically brought into contact with side surfaces of the terminal fittings of the connector, comprising:
a connector holder adapted to hold the connector and formed with probe insertion holes through which the probes are insertable to be brought into contact with the terminal fittings of the held connector,
a first and a second probe holders carrying the respective one or more probes, and
a relative displacement mechanism for relatively displacing or moving the first probe holder, the second probe holder and/or the connector holder with respect to each other so as to insert the probes into the probe insertion holes to be brought into contact with the terminal fittings of the held connector.

Accordingly, there is provided an electrical connection testing device of the side probe type with which it is sufficient to relatively move a probe holder toward and away from a connector holder for testing and, even if a connector is provided with cavities arrayed at two stages, probes can be simultaneously inserted into testing holes formed in the opposite side walls of the connector to test electrical connections of terminal fittings.

According to a preferred embodiment of the invention, the testing device further comprises a base portion to which the first probe holder is secured, and on which the connector holder and the second probe holder are so successively provided as to be movable toward and away from the first probe holder.

Preferably, the relative displacement mechanism comprises a pushing mechanism for pushing a receiving surface of the first probe holder and/or of the second probe holder preferably at the opposite side from the connector holder, the pushing mechanism being movably coupled to the first probe holder and/or to the second probe holder toward and away from it.

Most preferably, the second probe holder and the connector holder are moved toward the first probe holder by a movement of the pushing mechanism preferably toward the second probe holder, thereby positioning the probes at testing positions where they are insertable into testing holes of a connector held by the connector holder preferably from substantially opposite sides.

According to a further preferred embodiment of the invention, there is provided an electrical connection testing device for testing electrical connections of terminal fittings accommodated in a connector by inserting testing probes through testing holes formed in side walls of a connector housing extending in a direction normal to a terminal inserting direction to be elastically brought into contact with side surfaces of the terminal fittings inserted and locked in cavities, comprising:
a connector holder adapted to hold the connector and formed in its opposite side wall portions with probe insertion holes through which the probes are insertable to be brought into contact with the terminal fittings of the held connector,
a first and a second probe holders arranged in such a manner as to face the opposite side surfaces of the connector holder and carrying the probes,
a base portion to which the first probe holder is secured, and on which the connector holder and the second probe holder are so successively provided as to be movable toward and away from the first probe holder,
a pushing mechanism for pushing a receiving surface of the second probe holder at the opposite side from the connector holder, the pushing mechanism being movably coupled to the second probe holder toward and away from it,
the second probe holder and the connector holder being moved toward the first probe holder by a movement of the pushing mechanism toward the second probe holder, thereby positioning the probes at testing positions where they are insertable into testing holes of a connector held by the connector holder from opposite sides, and
the second probe holder and the connector holder being moved together to retracted positions where the connector can be mounted into and taken out of the connector holder via a retraction linking mechanism by a movement of the pushing mechanism away from the second probe holder.

Since the probes carried by the first and second probe holders are (at least partly) insertable into the testing holes of the connector accommodated in the connector holder from opposite sides according to the invention, the probes are brought into contact with the terminal fittings at the opposite sides to conduct an electrical connection test only by moving the second connector holder toward the first connector holder to the testing position by the pushing mechanism. On the other hand, the connector holder and the second probe holder are moved from the testing positions to the retracted positions where the connector was accommodated into the connector holder by the linking mechanism as the pushing mechanism is moved away from the second probe holder. Thus, operability can be improved.

Specifically, the pushing mechanism is at its retracted position when the connector is accommodated into the connector holder, and the first and second probe holders and the connector holder are at the retracted positions away from each other in this state and wait on standby at such positions where they do not interfere the connector being accommodated or taken out. When the receiving surface of the second probe holder is pushed toward the first probe holder by the pushing mechanism after the connector is accommodated into the connector holder, the second probe holder interferes one side of the connector holder to further push the connector holder toward the first probe holder. Thereby, spacings between the first probe holder and the connector holder and between the connector holder and the second probe holder are narrowed to consequently reach the specified testing positions. In these positions, the leading ends of the probes are inserted into the testing holes of the connector through the probe insertion holes of the connector holder and are elastically brought into contact with the respective terminal fittings to conduct an electrical connection test. As the pushing mechanism is moved away from the second probe holder after the electrical connection test, the connector holder and the second probe holder are returned to the retracted positions by the linking mechanism provided between the first probe holder and the connector holder and between the connector holder and the second probe holder, and the respective probes are withdrawn from the testing holes of the connector. Therefore, the connector can be taken out of the connector accommodating portion.

Preferably, the pushing mechanism comprises an operable lever pivotally mounted at an end of a base portion or at the connector holder about one point as a fulcrum, and a cam portion for pushing receiving surface of the second probe holder and/or a receiving surface of the first probe holder as the operable lever is pivoted.

Preferably, the relative displacement mechanism comprises a retraction linking mechanism for moving the second probe holder and the connector holder together to retracted positions where the connector can be at least partly mounted into and taken out of the connector holder preferably by a movement of the pushing mechanism away from the second probe holder.

Specifically, the relative displacement mechanism, preferably the retraction linking mechanism comprises springs provided between the first probe holder and the connector holder and between the connector holder and the second probe holder for biasing the holders in directions away from each other. With such a retraction linking mechanism, when a pushing force acting on the second probe holder is released by moving the pushing mechanism away from the second probe holder, the first probe holder and the connector holder, and the connector holder and the second probe holder are separated from each other to move together to the retracted positions by the biasing action of the springs.

Alternatively or additionally, the retraction linking mechanism may comprise first and second links provided between the connector holder and the second probe holder and between the second probe holder and the pushing mechanism. In such a case, no large force is required to move the second probe holder and the connector holder to the testing positions by the pushing mechanism since no spring is provided which is biased toward the retracted position and will bound back, thereby improving operability.

Preferably, the probe insertion holes are formed in the substantially opposite side wall portions of the connector holder and wherein first and a second probe holders are arranged in such a manner as to substantially face the opposite side surfaces of the connector holder.

Preferably, at least one of the first and second probe holders comprises a stopper for preventing relative movements of the first and second probe holders to the testing positions by interfering a retainer when the retainer mounted on the connector, preferably a terminal inserting surface of the connector, accommodated in the connector holder is insufficiently inserted. In the case that the retainer of the connector is insufficiently inserted, the second probe holder and the connector holder cannot be moved to the testing positions since the stopper comes into contact with the retainer projecting from the rear surface of the connector accommodated in the connector holder. Thus, the electrical connection test cannot be conducted since the probes are not in contact with the terminal fittings of the connector, thereby detecting the insufficiently inserted state of the retainer. Further, since the stopper is located in such a position as to block an insertion path of the connector into the connector holder when the second probe holder and the connector holder are in the testing positions, this prevents the leading ends of the probes from being damaged by forcible mounting of the connector into the connector holder.

According to a further preferred embodiment, a pair of probe holders is arranged in such a manner as to move toward and away from the opposite side surfaces of the connector holder.

Preferably, the relative movement mechanism comprises springs for biasing the probe holders toward the connector holder to be positioned at testing positions where the probes are inserted through the testing holes of the connector held in the connector holder.

Further preferably, the relative movement mechanism comprises a cam rotatable or pivotable about one point as a fulcrum and formed with a pair of pushing surfaces projecting in two substantially opposite directions with the fulcrum as a center, the cam being provided on one side wall of the connector holder, and the probe holders being formed with guide surfaces with which the corresponding pushing surfaces can come into contact,
wherein the pushing surfaces push the guide surfaces of the probe holders by the rotation of the cam, thereby moving the probe holders away from the connector holder, preferably against biasing forces of the springs to retracted positions where the connector can be at least partly inserted into and taken out of the connector holder.

According to still a further preferred embodiment of the invention, there is provided an electrical connection testing device for testing electrical connections of terminal fittings accommodated in a connector by inserting testing probes through testing holes formed in side walls of a connector housing extending in a direction normal to a terminal inserting direction to be elastically brought into contact with side surfaces of the terminal fittings inserted and locked in cavities, comprising:
a connector holder adapted to hold the connector and formed in its opposite side wall portions with probe insertion holes through which the probes are insertable to be brought into contact with the terminal fittings of the held connector,
a pair of probe holders arranged in such a manner as to move toward and away from the opposite side surfaces of the connector holder and carrying the probes,
springs for biasing the probe holders toward the connector holder to be positioned at testing positions where the probes are inserted through the testing holes of the connector held in the connector holder, and
a cam rotatable about one point as a fulcrum and formed with a pair of pushing surfaces projecting in two opposite directions with the fulcrum as a center, the cam being provided on one side wall of the connector holder, and the probe holders being formed with guide surfaces with which the pushing surfaces can come into contact,
wherein the pushing surfaces push the guide surfaces of the probe holders by the rotation of the cam, thereby moving the probe holders away from the connector holder against biasing forces of the springs to retracted positions where the connector can be inserted into and taken out of the connector holder.

As described above, since the probes are insertable into the testing holes of the connector accommodated in the connector holder from opposite sides by making the probe holders movable toward and away from the opposite side surfaces of the connector holder in the present invention, the probes are brought into contact with the terminal fittings at the opposite sides to conduct an electrical connection test only by moving the probe holders toward the connector holder. Operability can be improved since the probe holders are moved to the testing positions by the biasing forces of the springs and to the retracted positions by the rotation of the cam when the connector is to be accommodated into the connector holder.

Specifically, when the connector is to be accommodated into the connector holder, the guide surfaces of the probe holders are pushed by the pushing surfaces against the biasing forces of the springs as the cam is rotated, with the result that the probe holders are moved to the retracted positions away from the connector holder and the probes wait on standby at positions where they do not interfere the connector being accommodated or taken out. After the connector is accommodated, a rotating force of the cam is released. Accordingly, the probe holders are moved toward the connector holder by the biasing forces of the springs, the leading ends of the probes are inserted into the testing holes of the connector through the probe insertion holes of the connector holder and are elastically brought into contact with the respective terminal fittings to conduct an electrical connection test. If the cam is rotated again after the electrical connection test, the probes are withdrawn from the testing holes of the connector. Thus, the connector can be taken out of the connector holder.

Preferably, the cam is secured to an operable lever pivotal about the fulcrum and is rotated or pivoted by a pivotal movement of the operable lever. With such an arrangement, the cam rotating operation for moving the probe holders to the retracted positions by the lever action can be manually performed without any difficulty.

Preferably, at least one of the pair of probe holders comprises a stopper for preventing a movement of the connector holder to the testing position by interfering a retainer when the retainer mounted on the terminal inserting surface of the connector accommodated in the connector holder is insufficiently inserted. In the case that the retainer of the connector is insufficiently inserted, the probe holders cannot be moved to the testing positions since the stopper comes into contact with the retainer projecting from the rear surface of the connector accommodated in the connector holder. Thus, the electrical connection test cannot be conducted since the probes are not in contact with the terminal fittings of the connector, thereby detecting the insufficiently inserted state of the retainer. Further, since the stopper is located in such a position as to block an insertion path of the connector into the connector holder when the probe holder is in the testing position, this prevents the leading ends of the probes from being damaged by forcible mounting of the connector into the connector holder.

According to the invention, there is further provided an electrical connection testing method for testing electrical connections of terminal fittings at least partly accommodated in a connector, in particular for use with an electrical connection testing device according to the invention or an embodiment thereof, comprising the following steps:
at least partly inserting a connector having testing holes formed in side walls of a connector housing extending in a direction at an angle different from 0° or 180°, preferably substantially normal to a terminal mating direction of the terminal fittings with mating terminal fittings into a connector holder formed with probe insertion holes substantially corresponding to the testing holes;
relatively displacing (or moving) a first probe holder, a second probe holders carrying respective one or more probes and/or the connector holder with respect to each other (preferably from a retracted or spaced position to a testing position) so as to at least partly insert the probes into the probe insertion holes and the testing holes to be brought into contact with the terminal fittings of the held connector; and
testing the terminals fittings at least partly accommodated in the connector by means of the probes.

The inventive electrical connection testing device and method can be particularly suitably applied in the case that the terminal fittings to be tested are female terminal fittings. In other words, the probes cannot be easily brought into contact with the female terminal fittings using the prior art electrical connection testing device. However, if the testing holes are formed in positions of the connector housing corresponding to portions of the female terminal fittings except barrel portions, the leading ends of the probes inserted through the testing holes can be securely and easily brought into contact with the side surfaces of the female terminal fittings.

These and other objects, features and advantages of the present invention will become apparent upon reading of the following detailed description of preferred embodiments and accompanying drawings. It should be understood that even though embodiments are separately described, single features thereof may be combined to additional embodiments.
FIG. 1 is a front view of an electrical connection testing device for terminal fittings accommodated in a connector according to a first embodiment of the invention,
FIG. 2 is a plan view of the electrical connection testing device,
FIG. 3 is an exploded perspective view showing an essential portion of the electrical connection testing device,
FIG. 4 is a side view of a connector holder,
FIG. 5 is a front view of the connector holder in its retracted position,
FIGS. 6A and 6B are sections of the connector holder in its retracted position and testing position, respectively,
FIG. 7 is a section showing a state where a retainer is insufficiently inserted into a connector,
FIGS. 8A and 8B are front views of an electrical connection testing device according to a second embodiment in testing and retracted positions, respectively,

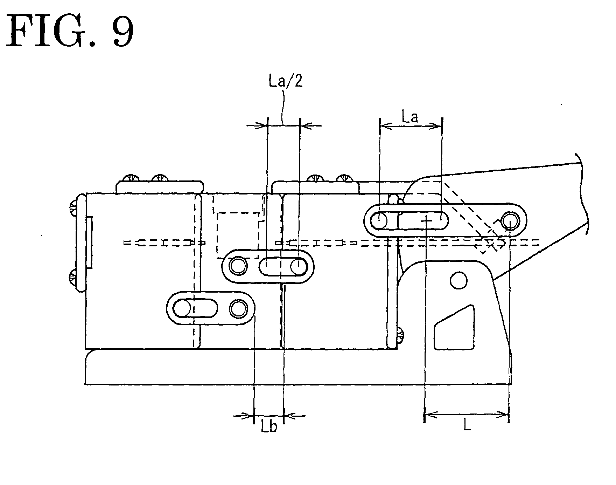

FIG. 9 is a diagram showing a dimensional relationship of oblong holes of first and second links,
FIG. 10 is a front view of an electrical connection testing device for terminal fittings accommodated in a connector according to one embodiment of the invention,
FIG. 11 is a plan view of the electrical connection testing device,
FIG. 12 is a side view of the electrical connection testing device,
FIG. 13 is an exploded perspective view showing an essential portion of the electrical connection testing device,
FIG. 14 is a front view showing retracted positions of connector holders,
FIG. 15(A) is a section of the electrical connection testing device when the connector holders are in their retracted positions, and FIG. 15(B) is a section of the electrical connection testing device when the connector holders are in their testing positions,
FIG. 16 is a section showing a mounted state of the connector having the retainer insufficiently inserted, and

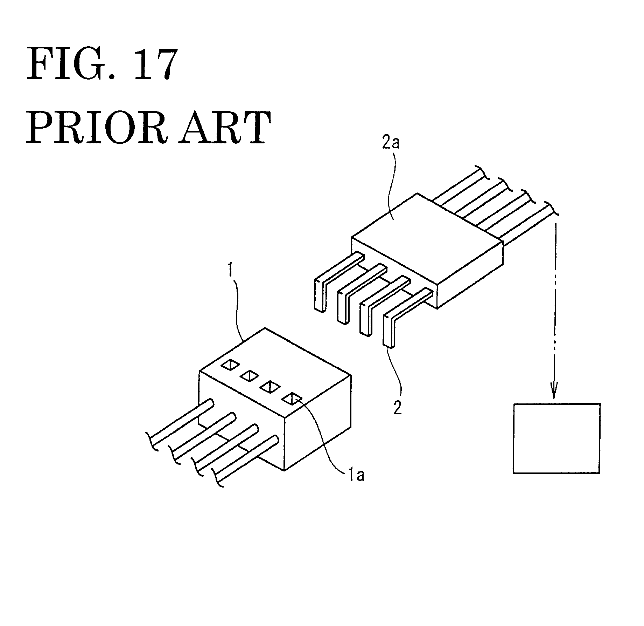

FIG. 17 is a schematic view showing a prior art electrical connection test.

Hereinafter, one preferred embodiment of the invention is described with reference to the accompanying drawings.

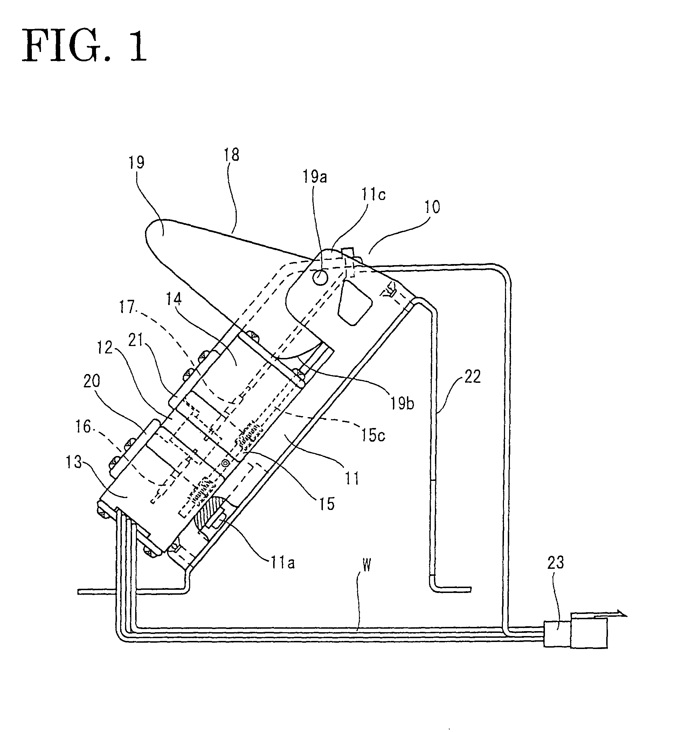

FIGS. 1 to 7 show an electrical connection testing device 10 according to this embodiment, which is constructed such that probe holders 13, 14 are so arranged on a base portion or plate 11 as to substantially face or correspond to a connector holder 12 therebetween. The testing device 10 is designed for a connector C in which electrical connection testing holes Cd are formed in side walls Cb of a connector housing Ca extending in a direction at an angle different from 0° or 180°, preferably substantially normal to a terminal fitting inserting direction (or mating direction of the illustrated terminal fitting T with an unillustrated mating terminal of a mating connector) and in which terminal fittings T are mounted at two stages.

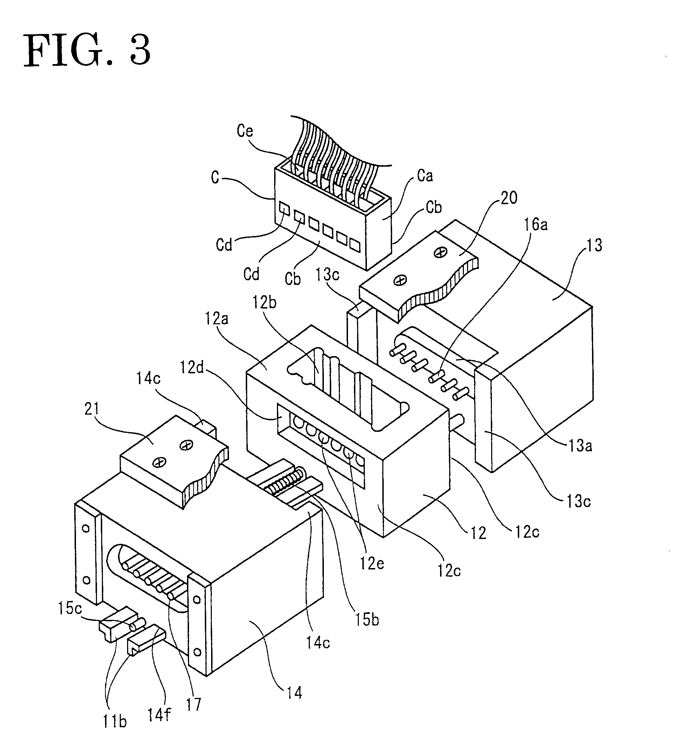

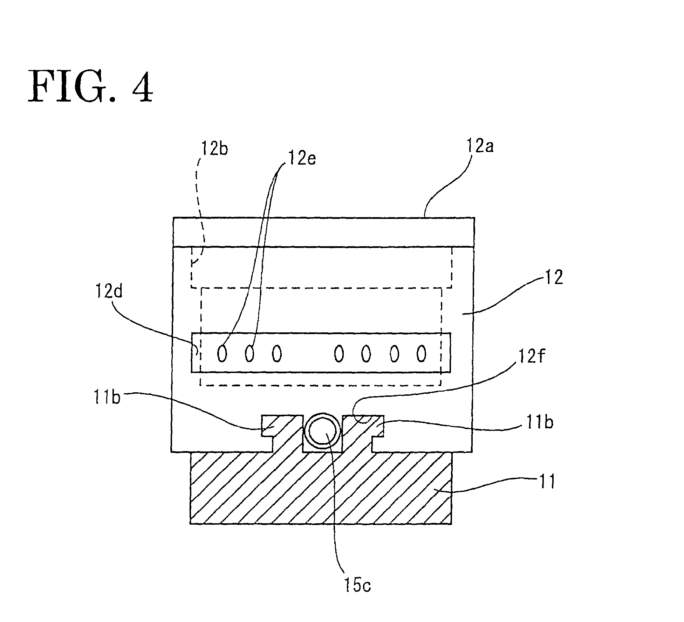

The first probe 13 is fixed or mounted at one end of the base portion 11 by a bolt 11a, and the connector holder 12 and the second probe holder 14 have guide grooves 12f, 14f formed in their lower surfaces. The guide grooves 12f, 14f are engageable with a pair of rails 11b projecting from the base portion 11 and extending in longitudinal direction, so that the connector holder 12 and the second probe holder 14 are slidable along the rails 11b (see FIGS. 3 and 4).

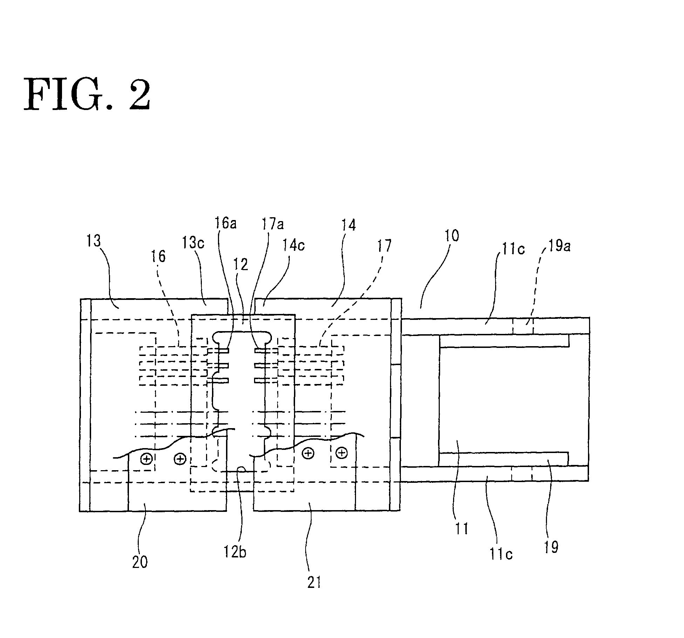

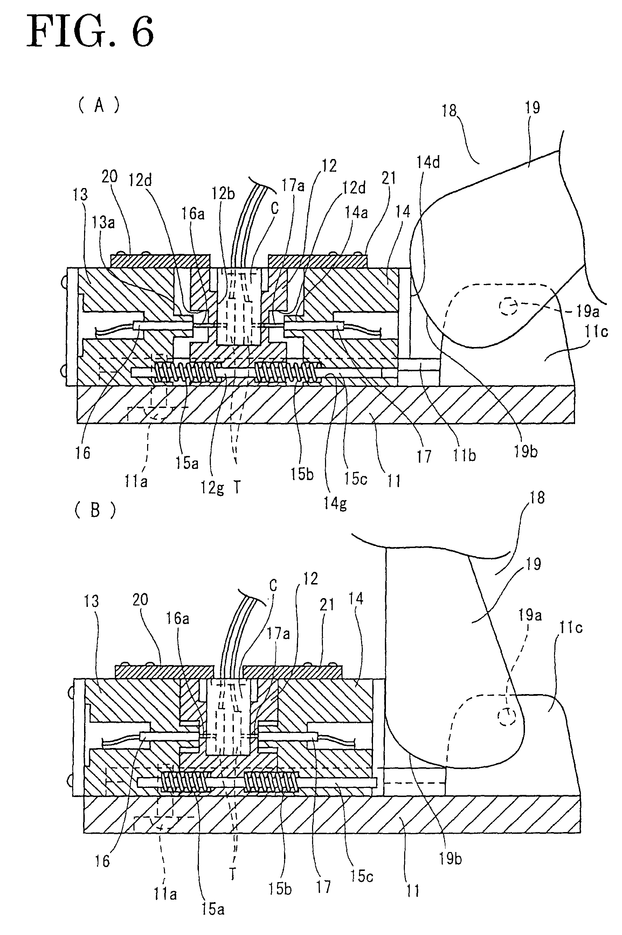

The connector holder 12 has a connector accommodating portion 12b formed in an upper surface 12a as shown in FIGS. 2 and 3. The configuration of the accommodating portion 12b is the substantially same as the outer configuration of the connector C to be tested so that the connector C can be at least partly accommodated (fitted or inserted) in the connector accommodating portion 12. When the connector C is at least partly fitted or inserted into the accommodating portion 12b of the connector holder 12 from above as shown in FIG. 6(B), it is held therein such that a surface of the connector C through which terminal fittings are inserted is faced up, and the side walls Cb formed with the testing holes Cd substantially face or correspond to the first and second probe holders 13, 14. Further, side wall portions 12c at the opposite sides of the connector holder 12 are formed with such recesses 12d as to substantially face the respective testing holes Cd of the connector C accommodated in the connector holder 12, and probe insertion holes 12e which can substantially communicate with the testing holes Cd at the bottoms of the respective recesses 12d are formed in the recesses 12d.

As shown in FIG. 6(A), one end of a slide shaft 15c is fixed to a bottom portion of the first probe holder 13 through guide holes 12g, 14g of the connector holder 12 and the second probe holder 14. Springs 15a, 15b mounted on the slide shaft 15c are provided in a compressed manner between the first probe holder 13 and the connector holder 12 and between the connector holder 12 and the second probe holder 14. The springs 15a, 15b form a retraction linking mechanism 15, and the first and second probe holders 13, 14 are forcibly moved away from the connector holder 12 to retracted positions (see FIG. 6(A)) by the biasing forces of the springs 15a, 15b.

Projections 13a, 14a engageable with the recesses 12d project from the surfaces of the first and second probe holders 13, 14 substantially facing the connector holder 12, and probes 16, 17 are mounted through the projections 13a, 14a. A plurality of probes 16, 17 are preferably mounted at the substantially same intervals as the testing grooves or holes Cd of the connector C to be tested, and contact elements 16a, 17a projecting at their leading ends can be elastically inserted into the testing holes Cd through probe insertion holes Cd. The contact elements 16a, 17a are preferably provided such in the probes 16, 17 that the might elastically retract e.g. by telescopically retracting into a body of the respective probes 16, 17 when their leading ends come into contact with the corresponding terminal fittings T accommodated in the connector C. Positions to which the connector holder 12 and the second probe holder 14 are moved toward the first probe holder 13 so that the contact elements 16a, 17a inserted into the testing holes Cd are preferably elastically brought into contact with the terminal fittings T of the connector C are referred to as testing positions (see FIG. 6(B)). In the testing positions, the facing surfaces of the first probe holder 13, the connector holder 12 and the second probe holder 14 are in contact with each other, and jaw portions 13c, 14c projecting at the opposite sides of the first and second probe holders 13, 14 are or can be fitted or slid on the outer surfaces of the opposite sides of the connector holder 12 for positioning.

On the other end of the base portion 11 adjacent to the second probe holder 14 is provided a pushing mechanism 18 for pushing a receiving surface 14d of the second probe holder 14 at the substantially opposite side from the connector holder 12. The pushing mechanism 18 is comprised of an operable lever 19 pivotally mounted about a pin 19a inserted through bearings 11c projecting at the front and rear sides at the other end of the base portion 11, and a cam portion 19b which can be pressed against the receiving surface 14d by the pivotal movement of the operable lever 19.

Plate-shaped stoppers 20, 21 are (integrally or unitarily) provided preferably on the upper surfaces of the first and second probe holders 13, 14 such that the end surfaces thereof project toward the accommodating portion 12b. The stoppers 20, 21 are adapted to prevent the connector C from coming out by facing the terminal inserting surface of the connector C accommodated in the accommodating portion 12b and to detect an insufficiently inserted state of a retainer Ce mounted preferably from the side of the terminal inserting surface for doubly locking the terminal fittings T by interfering the retainer Ce preferably during the insertion or fitting of the connector C into the connector accommodating space 12b.

Mount fittings 22 are fixed to the base plate 11 to secure the base portion 11 to a work table, and connectors 23, 24 for the connection with a testing apparatus are mounted at ends of wires W connected with the respective probes 16, 17.

Next, how the electrical connection test is conducted using the above electrical connection testing device 10 is described.

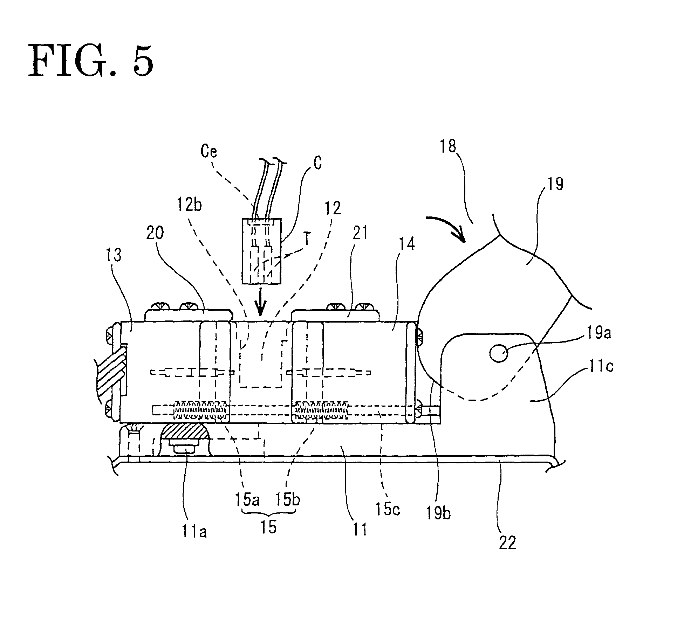

First, as shown in FIG. 5, with the operable lever 19 pivoted away from the second probe holder 14 to incline, the first and second probe holders 13, 14 are located at the retracted positions spaced apart from the connector holder 12 by a specified distance preferably at least partly by the biasing forces of the springs 15a, 15b of the retraction linking mechanism 15. In this state, since the stoppers 20, 21 are also retracted to open the entrance of the accommodating portion 12b of the connector holder 12, the connector C can be fitted into the accommodating portion 12b as shown in FIG. 6A. However, the first and second probe holders 13, 14 may be also moved to their retracted states or positions by the movement of the operable lever 19 only, i.e. by connecting them operably to the operable lever 19.

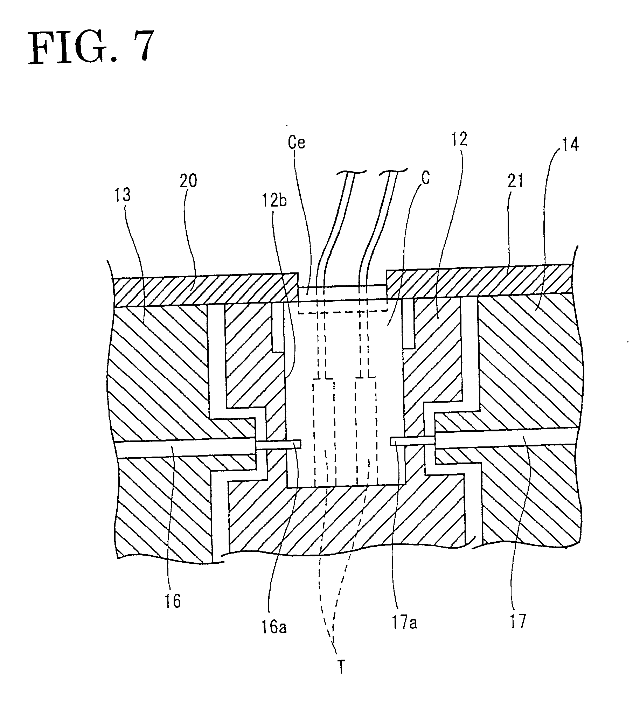

Subsequently, as shown in FIG. 6B, if the operable lever 19 is pivoted toward the second probe holder 14 preferably to a substantially standing position, the second probe holder 14 is pushed to move toward the connector holder 12 by the action of the cam portion 19b, and the connector holder 12 is further pushed toward the first probe holder 13 together with the second probe holder 14. If a retainer Ce of the connector C is insufficiently inserted to project from the end surface of the connector C, the second probe holder 14 and the connector holder 12 cannot reach the testing positions since the stoppers 20, 21 come into contact with the retainer Ce as shown in FIG. 7. The connector C fails the electrical connection test since the contact elements 16a, 17a of the probes 16, 17 are not brought into contact with the terminal fittings T in this state.

On the other hand, if the retainer Ce is completely or correctly inserted, the stoppers 20, 21 reach such positions as to face the opposite ends of the terminal inserting surface of the connector C as shown in FIG. 6(B), the connector C fitted in the accommodating portion 12b is prevented from coming out, thereby being securely positioned therein. At this stage, the contact elements 16a, 17a at the leading ends of the respective probes 16, 17 are or can be brought substantially into contact with the respective terminal fittings T through the corresponding probe insertion holes 12e and testing holes Cd, connection signals are outputted, and whether or not the terminal fittings T are properly arrayed is detected by a testing apparatus or circuit. If the operable lever 19 is pivoted again to reach the inclined state (see FIG. 6A) after the completion of the electrical connection test, the connector holder 12 and the second probe holder 14 are moved back to the retracted positions preferably by the biasing forces of the springs 15a, 15b, with the result that the connector C can be taken out of the accommodating portion 12b.

FIGS. 8A and 8B show an electrical connection testing device 30 according to a second embodiment having a retraction linking mechanism 35 different from that of the first embodiment. The retraction linking mechanism 35 is formed by first and second links 35a, 35b. The first and second links 35a, 35b are so provided between the operable lever 19 and the second probe holder 14 and between the second probe holder 14 and the connector holder 12 as to extend preferably over side surfaces preferably at least at one side. Although not directly relating to the retraction linking mechanism 35, a third link 35c for restricting the retracted position of the connector holder 12 is provided between the connector holder 12 and the first probe holder 13.

The first, second and third links 35a, 35b, 35c are mounted on the operable lever 19 and the connector holder 12 by inserting mount pins 35a-2, 35b-2, 35c-2 through mount holes 35a-1, 35b-1, 35c-1 formed at one ends of the respective links 35a, 35b, 35c. Oblong holes 35a-3, 35b-3, 35c-3 extending in longitudinal direction are formed at the other ends of the first, second and third links 35a, 35b, 35c, and slidable pins 35a-4, 35b-4, 35c-4 driven into the second probe holder 14 and the first probe holder 13 are slidably fitted into these oblong holes 35a-3, 35b-3, 35c-3.

Length La of the oblong hole 35a-3 of the first link 35a is set at a dimension (La = L - Lb) obtained by subtracting a specified (predetermined or predeterminable) moving distance Lb of the second probe holder 14 from the retracted position to the testing position from a a specified (predetermined or predeterminable) moving distance L of the mount pin 35a-2 according to the pivotal movement of the operable lever 19. On the other hand, the length of the oblong holes 35b-3, 35c-3 of the second and third links 35b, 35c are set at half the length of the oblong hole 35a-3, i.e. La/2. The construction of the second embodiment other than the linking mechanism 35 is similar or same as that of the first embodiment, no description is given thereon by identifying it by the same reference numerals.

Next, an operation of linking the retraction of the connector holder 12 and that of the second probe holder 14 using the linking mechanism 35 is described. FIG. 8(A) shows a state where the connector holder 12 and the second probe holder 14 are at the testing positions. In this state, the respective slidable pins 35a-4, 35b-4, 35c-4 are located inside the oblong holes 35a-3, 35b-3, 35c-3. As shown in FIG. 8(B), when the operable lever 19 is pivoted or rotated preferably to be inclined, the slidable pin 35a-4 comes into contact with the outer end of the oblong hole 35a-3 of the first link 35a to forcibly move the second probe holder 14 to the retracted position. Accordingly, the slidable pin 35b-4 comes into contact with the outer end of the oblong hole 35b-3 of the second link 35b to forcibly move the connector holder 12 to the retracted position. Further, the third link 35c comes into contact with the outer end of the oblong hole 35c-3 when the connector holder 12 reaches the retracted position, thereby functioning as a stopper for preventing the connector holder 12 from being retracted beyond the retracted position.

As is clear from the above description, the inventive electrical connection testing device can easily and securely test the connectors which have been conventionally difficult to test and is also applicable for the connectors in which the terminal fittings are mounted at two stages. Since the connector holder is provided with the stoppers for interfering the retainer when the retainer is insufficiently inserted to be mounted on the terminal inserting surface of the connector, the mounted state of the retainer can be detected prior to the electrical connection test.

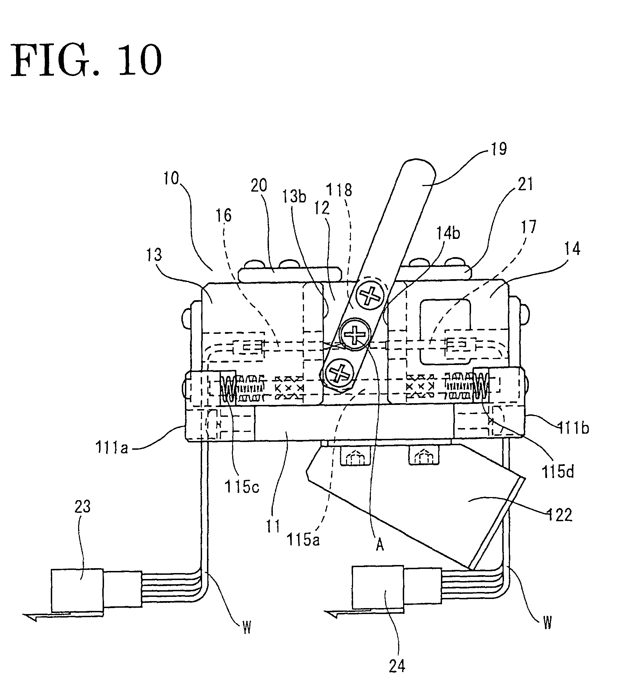

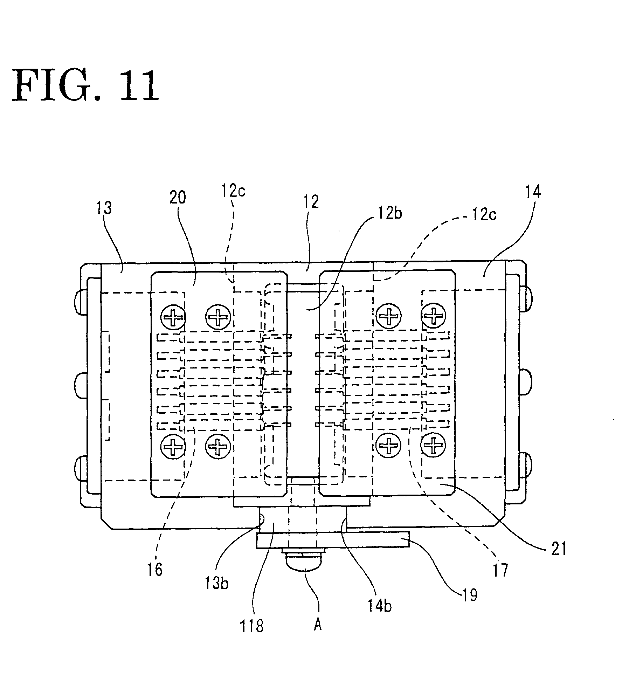

Hereinafter, one further preferred embodiment of the invention is described with reference to FIGS. 10 to 16.

FIGS. 10 to 16 show an electrical connection testing device 100 according to this embodiment, which is constructed such that probe holders 13, 14 are so arranged on a base plate 11 as to substantially face or correspond to a connector holder 12. The testing device 100 is designed for a connector C in which electrical connection testing holes Cd are formed in side walls Cb of a connector housing Ca extending in a direction at an angle different from 0° or 180°, preferably substantially normal to a terminal fitting inserting direction and in which terminal fittings T are mounted at two stages.

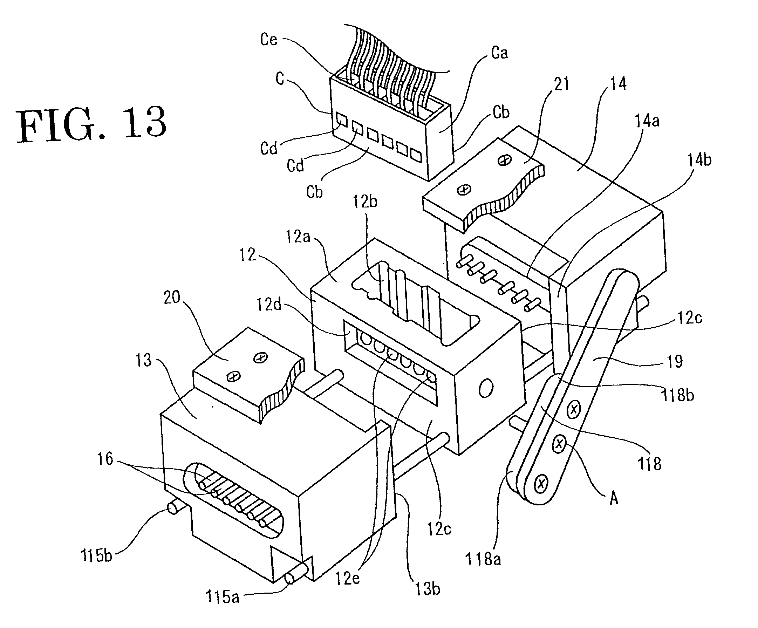

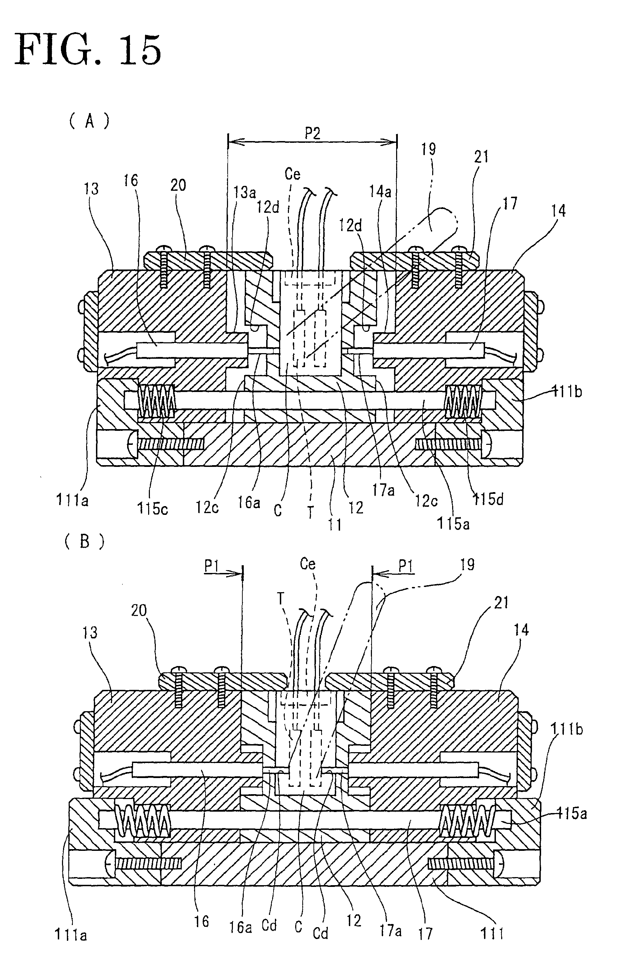

The connector holder 12 is or can be secured in the middle on the base plate 11, and a connector accommodating portion 12b is formed in an upper surface 12a as shown in FIG. 13. The configuration of the accommodating portion 12b is the substantially same as the outer configuration of the connector C to be tested so that the connector C can be at least partly accommodated (inserted or fitted) in the connector accommodating portion 12b. When the connector C is fitted or inserted into the accommodating portion 12b of the connector holder 12 from above as shown in FIG. 15(A), it is held therein such that a surface of the connector C through which terminal fittings are inserted is faced up, and the side walls Cb formed with the testing holes Cd substantially face or correspond to the probe holders 13, 14. Further, side wall portions 12c at the substantially opposite sides of the connector holder 12 are formed with such recesses 12d as to substantially face or correspond to the respective testing holes Cd of the connector C at least partly accommodated in the connector holder 12, and probe insertion holes 12e which can substantially communicate with the testing holes Cd at the bottoms of the respective recesses 12d are formed in the recesses 12d.

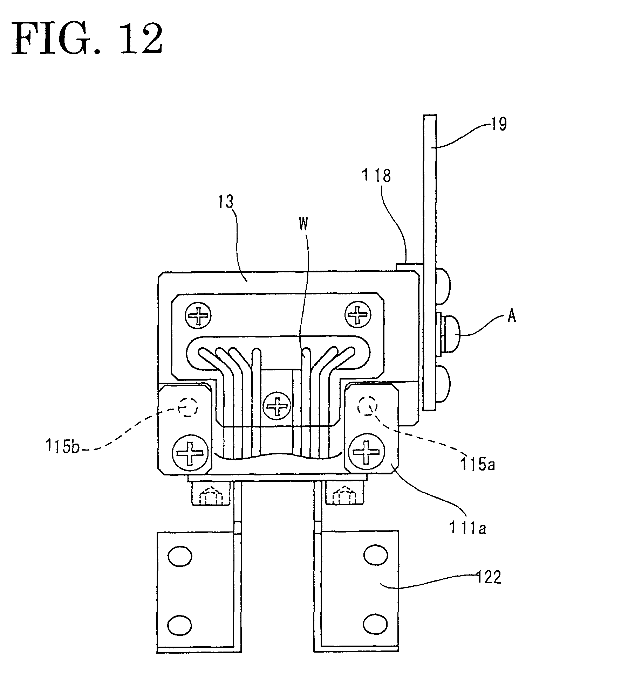

A pair of probe holders 13, 14 are so provided on the base plate 11 as to substantially face the opposite side wall portions 12c of the connector holder 12. As shown in FIGS. 12 and 13, a pair of slide shafts 115a, 115b are or can be inserted through bottom portions of the connector holder 12 and the probe holders 13, 14, and the opposite ends of the slide shafts 115a, 115b are supported by receiving plates 111a, 111b mounted on the opposite end surfaces of the connector holder 12. Thus, the probe holders 13, 14 are movable toward and away from the opposite side surfaces of the connector holder 12. Further, springs 15c, 15d mounted on the slide shafts 115a, 115b are mounted in a compressed state between the facing surfaces of the receiving plates 111a, 111b and the probe holders 13, 14 so as to bias the respective probe holders 13, 14 toward testing positions P1 where the probe holders 13, 14 are substantially in contact with the opposite side surfaces of the connector holder 12.

Projections 13a, 14a engageable with the recesses 12d are formed on the surfaces of the probe holders 13, 14 substantially facing the connector holder 12, and probes 16, 17 are so mounted through the projections 13a, 14a as to extend along directions toward and away from the probe holders 13, 14. A plurality of probes 16, 17 are mounted preferably at the substantially same intervals as the testing holes Cd of the connector C to be tested, such that preferably elastically projecting contact elements 16a, 17a at the leading ends of the probes 16, 17 are insertable into the testing holes Cd through the probe insertion holes 12e.

On one of the front and rear surfaces of the connector holder 12 not facing the probe holders 13, 14, a cam 118 rotatable about one point as a fulcrum A is provided. As shown in FIG. 13, this cam 118 is provided with a pair of pushing surfaces 118a, 118b projecting toward opposite sides, whereas guide surfaces 13b, 14b with which the pushing surfaces 118a, 118b can come into contact project from the probe holders 13, 14. The pushing surfaces 118a, 118b push the guide surfaces 13b, 14b as the cam 118 is rotated to move the probe holders 13, 14 together to retracted positions P2 spaced away from the connector holder 12.

The cam 118 is secured to the bottom end of an operable lever 19 pivotal about the fulcrum A and rotated via a lever mechanism by the operable lever 19. The cam 118 can forcibly move the probe holders 13, 14 in directions away from each other against the biasing forces of the springs 15c, 15d preferably regardless of whether it is rotated toward the probe holder 13 or toward the probe holder 14.

Plate-shaped stoppers 20, 21 are (integrally or unitarily) provided preferably on the upper surfaces of the probe holders 13, 14 such that the end surfaces thereof project toward the accommodating portion 12b. The stoppers 20, 21 are adapted to prevent the connector C from coming out by facing the terminal inserting surface of the connector C accommodated in the accommodating portion 12b and to detect an insufficiently inserted state of a retainer Ce mounted preferably from the side of the terminal inserting surface for doubly locking the terminal fittings T by interfering the retainer Ce preferably during the insertion or fitting of the connector C into the connector accommodating portion or space 12b.

Mount fittings 122 are fixed to the base plate 11 to secure the base plate 11 to a work table, and connectors 23, 24 for the connection with a testing apparatus are mounted at ends of wires W connected with the respective probes 16, 17.

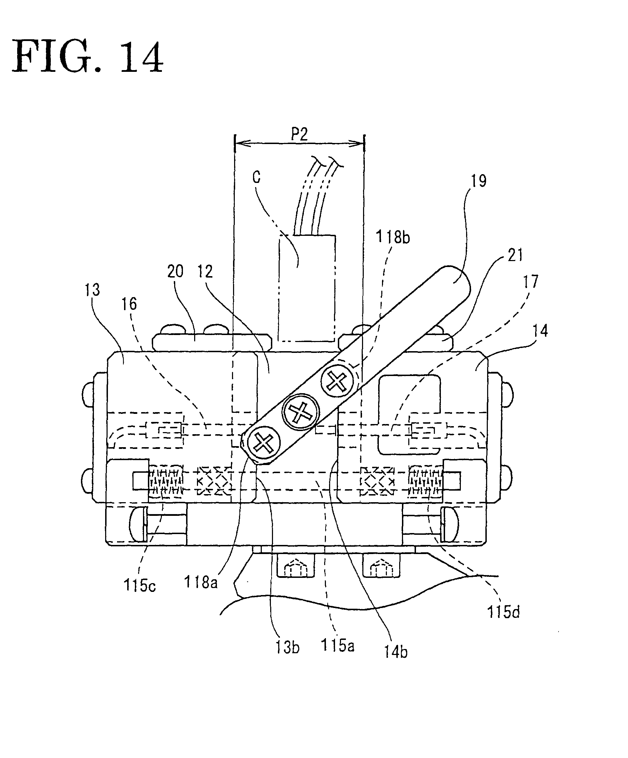

Next, how the electrical connection is tested using the above electrical connection testing device 100 is described. First, when the operable lever 19 is manually pivoted as shown in FIG. 14, the pushing surfaces 118a, 118b of the cam 118 push the guide surfaces 13b, 14b of the probe holders 13, 14, with the result that the probe holders 13, 14 are moved to the retracted positions P2 away from each other. At this time, since the stoppers 20, 21 are also moved to open the entrance of the accommodating portion 12b of the connector holder 12, the connector C is or can be at least partly fitted into the accommodating portion 12b of the connector holder 12 as shown in FIG. 15(A).

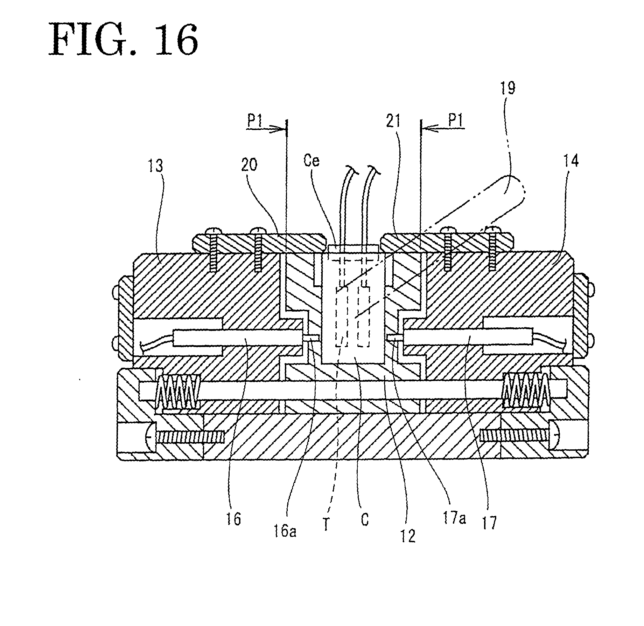

Subsequently, if the pivoted operable lever 19 is released, the probe holders 13, 14 are moved to the testing positions P1 where they are in contact with the connector holder 12 preferably by the biasing action of the springs 15c, 15d as shown in FIG. 15(B). At this time, if the retainer Ce of the connector C is insufficiently inserted to project from the end surface of the accommodating portion 12b, the stoppers 20, 21 are in contact with the retainer Ce as shown in FIG. 16. Thus, the probe holders 13, 14 cannot reach the testing positions P1. The connector C fails the electrical connection test since the contact elements 16a, 17a of the probes 16, 17 are not brought into contact with the terminal fittings T in this state.

On the other hand, if the retainer Ce is completely or correctly inserted, the stoppers 20, 21 can reach such positions as to face the opposite ends of the terminal inserting surface of the connector C as shown in FIG. 15(B), the connector C fitted in the accommodating portion 12b is prevented from coming out, thereby being securely positioned therein. At this stage, the contact elements 16a, 17a at the leading ends of the respective probes 16, 17 are brought into contact with the respective terminal fittings T through the corresponding probe insertion holes 12e and testing holes Cd, connection signals are outputted, and whether or not the terminal fittings T are properly arrayed or inserted or positioned is detected by the testing apparatus. After the completion of the electrical connection test, the operable lever 19 is pivoted again to move the probe holders 13, 14 to the retracted positions P2, with the result that the connector C can be taken out of the accommodating portion 12b.

The present invention is not limited to the foregoing embodiment. For example, when the operable lever 19 is pivoted to move the probe holders 13, 14 to the retracted positions P2, the operable lever 19 may be locked in this position by a locking means such as a locking claw provided between the operable lever 19 and the connector holder 12 or the base plate 11. In such a case, the connector C can be accommodated into the connector holder 12 without holding the operable lever 19 in its pivoted state. At the time of the electrical connection test, the probe holders 13, 14 can be moved to the testing positions P1 by the biasing forces of the springs 15c, 15d by releasing locking of the operable lever 19. The stoppers 20, 21 for detecting an insufficient insertion of the retainer by being provided on the probe holders 13, 14 may be provided on only either one of the probe holders 13, 14.

As is clear from the above description, the inventive electrical connection testing device and method can easily and securely test the connectors which have been conventionally difficult to test and is also applicable for the connectors in which the terminal fittings are mounted at two stages. Since the connector holder is provided with the stoppers for interfering the retainer when the retainer is insufficiently inserted to be mounted on the terminal inserting surface of the connector, the mounted state of the retainer can be detected prior to the electrical connection test.

### LIST OF REFERENCE NUMERALS

- T: terminal fitting
- C: connector
- Ca: connector housing
- Cb: side wall
- Cd: testing hole
- Ce: retainer
- 10, 30, 100: electrical connection testing device
- 11: base portion
- 12: connector holder
- 12a: upper surface
- 12b: accommodating portion
- 12c: side wall portion
- 12e: probe insertion hole
- 12f: guide groove
- 13: first probe holder
- 14: second probe holder
- 13b, 14b: guide surface
- 14d: receiving surface
- 15, 35: retraction linking mechanism
- 15a, 15b: spring
- 35a: first link
- 35b: second link
- 16, 17: probe
- 16a, 17a: contact element
- 18: pushing mechanism
- 19: operable lever
- 19b: cam portion
- 20, 21: stopper
- 115c, 115d: spring
- 118: cam
- 118a, 118b: pushing surface
- A: fulcrum
- P1: testing position
- P2: retracted position

## Claims

1. An electrical connection testing device (10; 30; 100) for testing electrical connections of terminal fittings (T) at least partly accommodated in a connector (C) by at least partly inserting testing probes (16; 17) through testing holes (Ce) formed in side walls (Cb) of a connector housing (Ca) extending in a direction at an angle different from 0° or 180°, preferably substantially normal to a terminal mating direction of the terminal fittings (T) with mating terminal fittings, so that the testing probes (16, 17) can be preferably elastically brought into contact with side surfaces of the terminal fittings (T) of the connector (C), comprising:
a connector holder (12) adapted to hold the connector (C) and formed with probe insertion holes (12e) through which the probes (16, 17) are insertable to be brought into contact with the terminal fittings (T) of the held connector (C),
a first and a second probe holders (13, 14) carrying the respective one or more probes (16, 17), and
a relative displacement mechanism (18; 19; 15; 35; 118) for relatively displacing the first probe holder (13), the second probe holder (14) and/or the connector holder (12) with respect to each other so as to insert the probes (16, 17) into the probe insertion holes (12e) to be brought into contact with the terminal fittings (T) of the held connector (C).

2. An electrical connection testing device according to claim 1, further comprising a base portion (11) to which the first probe holder (13) is secured, and on which the connector holder (12) and the second probe holder (14) are so successively provided as to be movable toward and away from the first probe holder (13).

3. An electrical connection testing device according to one or more of the preceding claims, wherein the relative displacement mechanism (18; 19; 15; 35; 118) comprises a pushing mechanism (18; 118) for pushing a receiving surface (14d; 13b, 14b) of the first probe holder (13) and/or of the second probe holder (14) preferably at the opposite side from the connector holder (12), the pushing mechanism (14d; 13b, 14b) being movably coupled to the first probe holder (13) and/or to the second probe holder (14) toward and away from it.

4. An electrical connection testing device according to claim 3, wherein the second probe holder (14) and the connector holder (12) are moved toward the first probe holder (13) by a movement of the pushing mechanism (18; 19) preferably toward the second probe holder (14), thereby positioning the probes (16, 17) at testing positions (FIG. 6B) where they are insertable into testing holes (Cd) of a connector (C) held by the connector holder (12) preferably from substantially opposite sides.

5. An electrical connection testing device according to claim 3 or 4, wherein the pushing mechanism (18; 118) comprises an operable lever (19) pivotally mounted at an end of a base portion (11) or at the connector holder (12) about one point as a fulcrum (A), and a cam portion (19b) for pushing a receiving surface (14d; 14a) of the second probe holder (14) and/or a receiving surface (13a) of the first probe holder (13) as the operable lever (19) is pivoted.

6. An electrical connection testing device according to one or more of the preceding claims, wherein the relative displacement mechanism (18; 19; 15; 35; 118) comprises a retraction linking mechanism (15; 35) for moving the second probe holder (14) and the connector holder (12) together to retracted positions (FIG. 6A) where the connector (C) can be at least partly mounted into and taken out of the connector holder (12) preferably by a movement of the pushing mechanism (18, 19) away from the second probe holder (14).

7. An electrical connection testing device according to one or more of the preceding claims, wherein the relative displacement mechanism (18; 19; 15; 35; 118), preferably the retraction linking mechanism (15; 35), comprises springs (15a; 15b) provided between the first probe holder (13) and the connector holder (12) and between the connector holder (12) and the second probe holder (14) for biasing the holders (13, 14) in directions away from each other.

8. An electrical connection testing device according to one or more of the preceding claims, wherein the relative displacement mechanism (18; 19; 15; 35; 118), preferably the retraction linking mechanism (15; 35) comprises first and second links (35a, 35b) provided between the connector holder (12) and the second probe holder (14) and between the second probe holder (14) and the relative displacement mechanism (18; 19; 15; 35; 118), preferably the pushing mechanism (18).

9. An electrical connection testing device according to one or more of the preceding claims, wherein the probe insertion holes (12e) are formed in the substantially opposite side wall portions (12c) of the connector holder (12) and wherein first and a second probe holders are arranged in such a manner as to substantially face the opposite side surfaces of the connector holder (12).

10. An electrical connection testing device according to one or more of the preceding claims, wherein at least one of the first and second probe holders (13, 14) comprises a stopper (20; 21) for preventing relative movements of the first and/or second probe holders (13, 14) to the testing positions (FIG. 6A; P1) by interfering a retainer (Ce) when the retainer (Ce) mounted on the connector (C), preferably on a terminal inserting surface thereof, accommodated in the connector holder (12) is insufficiently inserted.

11. An electrical connection testing device according to one or more of the preceding claims,
wherein a pair of probe holders (13, 14) is arranged in such a manner as to move toward and away from the opposite side surfaces of the connector holder (12).

12. An electrical connection testing device according to claim 11, wherein the relative movement mechanism (18; 19; 15; 35; 118) comprises springs (115c, 115d) for biasing the probe holders (13, 14) toward the connector holder (12) to be positioned at testing positions (P1) where the probes (16, 17) are inserted through the testing holes (Cd) of the connector (C) held in the connector holder (12).

13. An electrical connection testing device according to claim 11 or 12, wherein the relative movement mechanism (18; 19; 15; 35; 118) comprises a cam (118) rotatable or pivotable about one point as a fulcrum (A) and formed with a pair of pushing surfaces (118a; 118b) projecting in two substantially opposite directions with the fulcrum (A) as a center, the cam (118) being provided on one side wall of the connector holder (12), and the probe holders (13, 14) being formed with guide surfaces (13a, 14a) with which the corresponding pushing surfaces (118a, 118b) can come into contact,
wherein the pushing surfaces (118a, 118b) push the guide surfaces (13a, 14a) of the probe holders (13, 14) by the rotation of the cam (118), thereby moving the probe holders (13, 14) away from the connector holder (12), preferably against biasing forces of the springs (115c, 115d) to retracted positions (P2) where the connector (C) can be at least partly inserted into and taken out of the connector holder (12).

14. An electrical connection testing device according to claim 13, wherein the cam (118) is secured to an operable lever (19) pivotal about the fulcrum (A) and is rotated by a pivotal movement of the operable lever (19).

15. An electrical connection testing method for testing electrical connections of terminal fittings (T) at least partly accommodated in a connector (C), comprising the following steps:
at least partly inserting a connector (C) having testing holes (Ce) formed in side walls (Cb) of a connector housing (Ca) extending in a direction at an angle different from 0° or 180°, preferably substantially normal to a terminal mating direction of the terminal fittings (T) with mating terminal fittings into a connector holder (12) formed with probe insertion holes (12e) substantially corresponding to the testing holes (Ce);
relatively displacing (or moving) a first probe holder (13), a second probe holders (13, 14) carrying respective one or more probes (16, 17) and/or the connector holder (12) with respect to each other so as to at least partly insert the probes (16, 17) into the probe insertion holes (12e) and the testing holes (Cd) to be brought into contact with the terminal fittings (T) of the held connector (C); and
testing the terminals fittings (T) at least partly accommodated in the connector (C) by means of the probes.
